(19) Europäisches Patentamt
European Patent Office
Office européen des brevets

(11) **EP 4 186 690 A1**

(12) **EUROPEAN PATENT APPLICATION**
published in accordance with Art. 153(4) EPC

(43) Date of publication:
**31.05.2023 Bulletin 2023/22**

(21) Application number: **21847068.0**

(22) Date of filing: **16.07.2021**

(51) International Patent Classification (IPC):
**B32B 9/00** (2006.01)   **B32B 17/00** (2006.01)
**C03C 17/38** (2006.01)   **C03C 21/00** (2006.01)
**G09F 9/00** (2006.01)   **B32B 7/023** (2019.01)

(52) Cooperative Patent Classification (CPC):
**B32B 7/023; B32B 9/00; B32B 17/00; C03C 17/38;
C03C 21/00; G09F 9/00**

(86) International application number:
**PCT/JP2021/026878**

(87) International publication number:
**WO 2022/019243 (27.01.2022 Gazette 2022/04)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.07.2020 JP 2020125648**

(71) Applicant: **AGC INC.**
**Chiyoda-ku,**
**Tokyo 1008405 (JP)**

(72) Inventors:
• **TAKEMOTO Kazuya**
**Tokyo 100-8405 (JP)**
• **MORIMOTO Tamotsu**
**Tokyo 100-8405 (JP)**
• **INOUE Aichi**
**Tokyo 100-8405 (JP)**

(74) Representative: **Müller-Boré & Partner**
**Patentanwälte PartG mbB**
**Friedenheimer Brücke 21**
**80639 München (DE)**

(54) **ANTI-REFLECTIVE FILM-ATTACHED TRANSPARENT SUBSTRATE AND IMAGE DISPLAY DEVICE**

(57)    The present embodiment relates to an anti-reflective film-attached transparent substrate comprising: a transparent substrate having two main surfaces; and a diffusion layer and an anti-reflective film provided in this order on one of the main surfaces of the transparent substrate, wherein the luminous transmittance, the transmitted color b* value under a D65 light source, the luminous reflectance (SCI Y) of the outermost surface layer of the anti-reflective film, and the sheet resistance of the anti-reflective film are set to specific ranges, the anti-reflective film has a laminated structure in which at least two dielectric layers having different refractive indexes are laminated, and a value of diffusion and the brightness (SCE L*) of diffused light are set to specific ranges.

FIG. 1

**Description**

TECHNICAL FIELD

The present invention relates to an anti-reflective film-attached transparent substrate and an image display device including the anti-reflective film-attached transparent substrate.

BACKGROUND ART

In recent years, from the viewpoint of an aesthetic appearance, a method of installing a cover glass on a front surface of an image display device such as a liquid crystal display has been used. In this method, reflection due to the cover glass reflecting external light is a problem, and a multilayer film is often provided on the surface of the cover glass in order to solve such a problem. However, in an anti-reflective film in the related art, a boundary line between a black frame portion and an image display portion in the image display device is conspicuous, and the aesthetic appearance is poor.

Therefore, there has been known that when light absorptivity is imparted to the anti-reflective film, which is a multilayer film in which at least two dielectric layers having different refractive indices are laminated, the boundary line between the black frame portion and the image display portion in the image display device can be made inconspicuous, and reflection from an interface between the cover glass and the anti-reflective film can be prevented.

For example, Patent Literature 1 discloses an anti-reflective film-attached transparent substrate, which has light absorptivity and insulating property. Patent Literature 2 discloses a transparent conductive laminate in which a silicon oxide layer and a copper layer are laminated in order. Patent Literature 3 discloses an anti-reflective film having a coating made of a high refractive index material and a coating made of a low refractive index material on a surface of a glass plate, and the coating made of a low refractive index material is disposed on the outermost surface.

However, there has been a demand for an anti-reflective film-attached transparent substrate having a higher aesthetic appearance with a black feeling.

CITATION LIST

PATENT LITERATURE

    Patent Literature 1: JP2018-115105A
    Patent Literature 2: JP2016-068470A
    Patent Literature 3: JP2008-201633A

SUMMARY OF INVENTION

TECHNICAL PROBLEM

An object of the present invention is to provide an anti-reflective film-attached transparent substrate which has light absorptivity and insulating property and whose transmitted light is not yellowish, and an image display device including the anti-reflective film-attached transparent substrate.

SOLUTION TO PROBLEM

An anti-reflective film-attached transparent substrate according to an aspect of the present invention is an anti-reflective film-attached transparent substrate including: a transparent substrate having two main surfaces; and a diffusion layer and an anti-reflective film on one main surface of the transparent substrate, which are provided in this order, in which

    (A) a luminous transmittance is 20% to 90%, (B) a transmission color b* value under a D65 light source is 5 or less, (C) a luminous reflectance (SCI Y) of an outermost layer of the anti-reflective film is 0.4% or less, (D) a sheet resistance of the anti-reflective film is $10^4$ Q/square or more, (E) the anti-reflective film has a laminated structure in which at least two dielectric layers having different refractive indices are laminated, and (F) a Diffusion value is 0.2 or more and a diffused light brightness (SCE L*) is 4 or less.

It is preferable that, in the anti-reflective film-attached transparent substrate according to the aspect of the present invention, at least one of the dielectric layers is mainly formed of an Si oxide, at least another layer in layers of the laminated structure is mainly formed of a mixed oxide of an oxide containing at least one element selected from the group A consisting of Mo and W and an oxide containing at least one element selected from the group B consisting of Si, Nb, Ti, Zr, Ta, Al, Sn, and In, and a content of the elements of the group B contained in the mixed oxide is 65 mass% or less with respect to a total of the elements of the group A contained in the mixed oxide and the elements of the group B contained in the mixed oxide.

It is preferable that the anti-reflective film-attached transparent substrate according to the aspect of the present invention further includes an anti-fouling film on the anti-reflective film.

It is preferable that, in the anti-reflective film-attached transparent substrate according to the aspect of the present invention, the transparent substrate is a glass substrate.

It is preferable that, in the anti-reflective film-attached transparent substrate according to the aspect of the present invention, the transparent substrate is at least one resin selected from a polyethylene terephthalate, polycarbonate, acrylic, silicone or triacetylcellulose resin film.

It is preferable that, in the anti-reflective film-attached transparent substrate according to the aspect of the present invention, the transparent substrate is a laminate of a glass and at least one resin selected from a polyethylene terephthalate, polycarbonate, acrylic, silicone or triacetylcellulose resin film.

It is preferable that, in the anti-reflective film-attached transparent substrate according to the aspect of the present invention, the glass is chemically strengthened.

It is preferable that, in the anti-reflective film-attached transparent substrate according to the aspect of the present invention, the main surface of the transparent substrate on a side where the anti-reflective film is provided is subjected to an anti-glare treatment on the main surface on a side where the anti-reflective film is provided.

It is preferable that, in the anti-reflective film-attached transparent substrate according to the aspect of the present invention, an image display device includes the anti-reflective film-attached transparent substrate.

ADVANTAGEOUS EFFECTS OF INVENTION

According to one aspect of the present invention, an anti-reflective film-attached transparent substrate which has light absorptivity and insulating property and whose transmitted light is not yellowish is provided.

With the above features, the anti-reflective film-attached transparent substrate according to the present embodiment is suitable as a cover glass in an image display device, particularly a cover glass in an image display device to be mounted on a vehicle or the like, such as an image display device of a navigation system to be mounted on a vehicle or the like.

BRIEF DESCRIPTION OF DRAWINGS

[FIG. 1] FIG. 1 is a cross-sectional view schematically showing a configuration example of an anti-reflective film-attached transparent substrate.

[FIG. 2] FIG. 2 is a diagram schematically showing an example of a measuring device used when measuring a reflected image diffusivity index value R of the anti-reflective film-attached transparent substrate.

DESCRIPTION OF EMBODIMENTS

Hereinafter, embodiments of the present invention are described in detail.

An anti-reflective film-attached transparent substrate according to the present embodiment includes: a transparent substrate having two main surfaces; and a diffusion layer and an anti-reflective film on one main surface of the transparent substrate, which are provided in this order, in which (A) a luminous transmittance is 20% to 90%, (B) a transmission color b* value under a D65 light source is 5 or less, (C) a luminous reflectance (SCI Y) of an outermost layer of the anti-reflective film is 0.4% or less, (D) a sheet resistance of the anti-reflective film is $10^4$ $\Omega$/square or more, (E) the anti-reflective film has a laminated structure in which at least two dielectric layers having different refractive indices are laminated, and (F) a Diffusion value is 0.2 or more, and a diffused light brightness (SCE L*) is 4 or less.

One embodiment of the present invention is an anti-reflective film-attached transparent substrate including an anti-reflective film on one main surface of a transparent substrate.

(Luminous Transmittance)

The anti-reflective film-attached transparent substrate according to the present embodiment has a luminous transmittance of 20% to 90%. When the luminous transmittance is within the above range, the anti-reflective film-attached transparent substrate has appropriate light absorptivity. Therefore, when the anti-reflective film-attached transparent substrate is used as a cover glass in an image display device, reflection from an interface between the cover glass and a multilayer film can be prevented. Accordingly, a photopic contrast of the image display device is improved.

The luminous transmittance can be measured by a method specified in JIS Z 8709 (1999) as described in Examples to be described later.

The luminous transmittance of the anti-reflective film-attached transparent substrate according to the present embodiment is preferably 50% to 90%, and more preferably 60% to 90%.

(Transmission Color b* Value under D65 Light Source)

In the anti-reflective film-attached transparent substrate according to the present embodiment, the multilayer film has a transmission color b* value under a D65 light source of 5 or less. When the b* value is within the above range, the transmitted light is not yellowish, and therefore, the anti-reflective film-attached transparent substrate is suitably used as a cover glass in an image display device.

The transmission color b* value under the D65 light source can be measured by a method specified in JIS Z 8729 (2004) as described in Examples to be described later.

The upper limit of the b* value of the anti-reflective film-attached transparent substrate according to the present embodiment is more preferably 3 or less, and still more preferably 2 or less. The lower limit of the b* value is preferably -6 or more, and more preferably -4 or more. The above range is preferred since the transmitted light is colorless and the transmitted light is not blocked.

(Luminous Reflectance of Outermost Layer)

In the anti-reflective film-attached transparent substrate according to the present embodiment, the outermost layer of the anti-reflective film has a luminous reflectance of 0.4% or less. The luminous reflectance of the outermost surface can be measured in a state where back surface reflection is eliminated by attaching a black tape to a back surface of the transparent substrate. When the luminous reflectance of the anti-reflective film is within the above range, the effect of preventing external light from being reflected on a screen is high when the anti-reflective film-attached transparent substrate is used as a cover glass in an image display device.

The luminous reflectance can be measured by a method specified in JIS Z 8701 (1999) as described in Examples to be described later.

In the anti-reflective film-attached transparent substrate according to the present embodiment, the luminous reflectance of the outermost layer of the anti-reflective film is 0.4% or less, more preferably 0.35% or less, and still more preferably 0.3% or less.

(Luminous Reflectance)

In the anti-reflective film-attached transparent substrate according to the present embodiment, the anti-reflective film has a luminous reflectance of preferably 1.6% or less in a state where a liquid crystal display is disposed on a non-film-formed side and the liquid crystal display is turned off. When the luminous reflectance of the anti-reflective film is within the above range, the effect of preventing external light from being reflected on a screen is high when the anti-reflective film-attached transparent substrate is used as a cover glass in an image display device.

The luminous reflectance of the anti-reflective film in the state where the liquid crystal display is disposed on the non-film-formed side can be measured by a method specified in JIS Z 8701 (1999) as described in Examples to be described later.

The luminous reflectance of the anti-reflective film is preferably 1.6% or less, and more preferably 1.3% or less in the state where the liquid crystal display is disposed on the non-film-formed side of the anti-reflective film-attached transparent substrate according to the present embodiment.

(Sheet Resistance)

In the anti-reflective film-attached transparent substrate according to the present embodiment, the anti-reflective film has a sheet resistance of $10^4$ $\Omega$/square or more. When the sheet resistance of the anti-reflective film is within the above range, the anti-reflective film has insulating property. Therefore, even when a touch panel is provided in a case where the anti-reflective film-attached transparent substrate is used as a cover glass in an image display device, a change in capacitance due to contact of a finger necessary for a capacitive touch sensor is maintained, and the touch panel can be activated.

The sheet resistance can be measured by a method specified in JIS K 6911 as described in Examples to be described later.

In the anti-reflective film-attached transparent substrate according to the present embodiment, the sheet resistance of the anti-reflective film is preferably $10^6$ Ω/square or more, and more preferably $10^8$ Ω/square or more.

(Diffusion Value)

The Diffusion value is a degree of reflection of an ambient image on the transparent substrate, that is, an index relating to an anti-glare property. A larger value indicates that reflection is further prevented and the anti-glare property of the transparent substrate is higher.

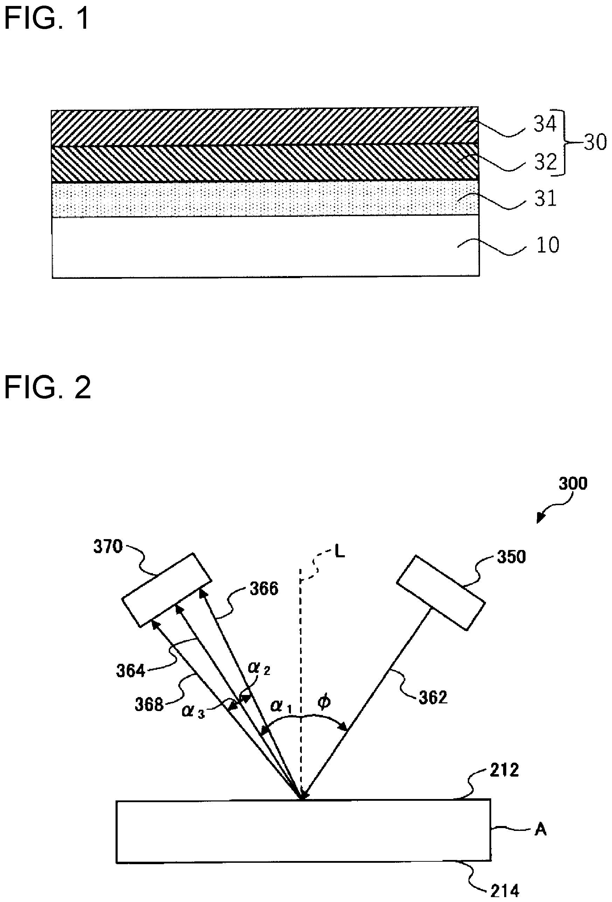

Next, referring to FIG. 2, a method for measuring the Diffusion value of the transparent substrate is described.

FIG. 2 schematically shows an example of a measuring device used when measuring the Diffusion value.

As shown in FIG. 2, a measuring device 300 includes a light source 350 and a detector 370, and a sample to be measured, that is, a transparent substrate A is positioned in the measuring device 300.

The transparent substrate A has a first surface 212 and a second surface 214. The light source 350 emits slit-like first light 362 with a width of 101 mm toward the transparent substrate A. The detector 370 receives reflected light reflected at a predetermined angle from the first surface 212 and detects a luminance thereof.

The transparent substrate A is positioned such that the first surface 212 faces the light source 350 and the detector 370. Therefore, the light detected by the detector 370 is reflected light reflected by the transparent substrate A.

Further, in the case of subjecting one surface of the transparent substrate A to an anti-glare treatment, the surface subjected to an anti-glare treatment is the first surface 212 of the transparent substrate A. That is, in this case, the transparent substrate A is positioned in the measuring device 300 with the surface subjected to an anti-glare treatment facing the light source 350 and the detector 370. A liquid crystal display is bonded to a back surface of the transparent substrate A via an acrylic adhesive.

During the measurement, the first light 362 is emitted from the light source 350 of the measuring device 300 toward the transparent substrate A.

The first light 362 is incident on the transparent substrate A at an angle $\varphi$ that is 2° counterclockwise with respect to a direction of a normal line L of the transparent substrate A. More precisely, the angle $\varphi$ is in a range of $2°\pm0.1°$, since errors are included in actual measurement.

Next, the detector 370 is used to measure a luminance $R_1$ of light specularly reflected from the first surface 212 of the transparent substrate A (hereinafter referred to as "first reflected light 364").

Actually, an angle (first angle $\alpha_1$) of the first reflected light 364 with respect to the normal line L is $\alpha_1 = -2°\pm0.1°$ because $\alpha_1 = -\varphi$. The minus (-) sign indicates that the angle is tilted counterclockwise with respect to the normal line L, and the plus (+) sign indicates that the angle is tilted clockwise with respect to the normal line.

Here, since the first angle $\alpha_1$ of the first reflected light 364 is used as a reference, the angle $\alpha_1$ is defined as $0°\pm0.1°$.

A luminance $R_2$ of reflected light reflected at a second angle $\alpha_2$ from the first surface 212 of the transparent substrate A (hereinafter referred to as "second reflected light 366") and a luminance $R_3$ of reflected light reflected at a third angle $\alpha_3$ from the first surface 212 of the transparent substrate A (hereinafter referred to as "third reflected light 368") are similarly measured.

Here, the second angle $\alpha_2$ is $\alpha_2 = -0.5°\pm0.1°$ with the first angle $\alpha_1$ as a reference. The third angle $\alpha_3$ is $\alpha_3 = +0.5°\pm0.1°$ with the first angle $\alpha_1$ as a reference.

Using the obtained luminances $R_1$, $R_2$, and $R_3$, the Diffusion value of the transparent substrate A is calculated according to the following equation (2):

$$\text{Diffusion value} = (R_2+R_3)/(2 \times R_1) \qquad \text{equation (2)}$$

It has been confirmed that this Diffusion value correlates with a determined result of reflected image diffusivity by the observer's visual observation, and exhibits a behavior close to human visual perception. For example, a transparent substrate exhibiting a large Diffusion value (a value close to 1) tends to be excellent in reflected image diffusivity, and conversely, a transparent substrate exhibiting a small Diffusion value tends to be poor in reflected image diffusivity.

Such measurement can be performed, for example, by using the device SMS-1000 manufactured by DM&S.

In the case of using this device, a C1614A lens with a focal length of 16 mm is used with an aperture of 5.6. In addition, a distance from the first surface 212 of the transparent substrate A to the camera lens is approximately 300 mm, and the Imaging Scale is set within a range of 0.0276 to 0.0278.

In the anti-reflective film-attached transparent substrate according to the present embodiment, the Diffusion value is 0.2 or more, and preferably 0.3 or more.

(Diffused Light Brightness)

In the anti-reflective film-attached transparent substrate according to the present embodiment, the anti-reflective film has a diffused light brightness (L*) of 4 or less. When the diffused light brightness of the anti-reflective film is within the above range, the effect of preventing external light from being reflected on a screen is high when the anti-reflective film-attached transparent substrate is used as a cover glass in an image display device.

The diffused light brightness (L*) can be measured by a method specified in JIS Z 8722 (2009) as described in Examples to be described later.

In the anti-reflective film-attached transparent substrate according to the present embodiment, the diffused light brightness (L*) of the anti-reflective film is 4 or less, and preferably 3.5 or less.

The transparent substrate according to the present embodiment is not particularly limited as long as it is a transparent substrate having excellent translucency. Examples thereof include a glass and a resin.

In the anti-reflective film-attached transparent substrate according to the present embodiment, the multilayer film preferably has the following configuration.

FIG. 1 is a cross-sectional view schematically showing a configuration example of the anti-reflective film-attached transparent substrate. A diffusion layer 31 is formed on a transparent substrate 10, and a multilayer film (anti-reflective film) 30 is formed on the diffusion layer 31.

The multilayer film (anti-reflective film) 30 shown in FIG. 1 has a laminated structure in which two dielectric layers 32 and 34 having different refractive indices are laminated. By laminating the dielectric layers 32 and 34 having different refractive indices, reflection of light is prevented. The dielectric layer 32 is a high refractive index layer, and the dielectric layer 34 is a low refractive index layer.

In the multilayer film (anti-reflective film) 30 shown in FIG. 1, the dielectric layer 32 is preferably formed of a mixed oxide of an oxide containing at least one element selected from the group A consisting of Mo and W and an oxide containing at least one element selected from the group B consisting of Si, Nb, Ti, Zr, Ta, Al, Sn, and In.

In the mixed oxide, the content of the elements of the group B contained in the mixed oxide (hereinafter, described as a group B content) is 65 mass% or less with respect to a total of the elements of the group A contained in the mixed oxide and the elements of the group B contained in the mixed oxide.

The layer 34 is preferably formed of $SiO_x$.

The layer 32 is preferably formed of a mixed oxide of an oxide containing at least one element selected from the group A consisting of Mo and W and an oxide containing at least one element selected from the group B consisting of Si, Nb, Ti, Zr, Ta, Al, Sn, and In. Among these, Mo is preferred for the group A, and Nb is preferred for the group B.

The use of the layer 34, which is an oxygen-deficient silicon oxide layer, and the layer 32 containing Mo and Nb is preferred since the silicon oxide layer is not yellowish by using Mo and Nb even when oxygen is deficient, while the oxygen-deficient silicon oxide layer is generally yellowish in visible light.

A refractive index of the layer 32 at a wavelength of 550 nm is preferably 1.8 to 2.3 from the viewpoint of the transmittance with respect to the transparent substrate.

An extinction coefficient of the layer 32 is preferably 0.005 to 3, and more preferably 0.04 to 0.38. When the extinction coefficient is 0.005 or more, a desired absorption rate can be realized with an appropriate number of layers. Further, when the extinction coefficient is 3 or less, it is relatively easy to achieve both the reflection color hue and the transmittance.

In the present embodiment, when those having high light absorptivity in the entire wavelength range of visible light are used as fine particles to be dispersed in the dielectric layer 32, the transmitted light is more effectively prevented from being yellowish. In the present embodiment, as the fine particles to be dispersed in the dielectric layer 32, at least one selected from the group consisting of Ag, Mo, W, Cu, Au, Pd, Pt, Ir, Ni, Co, Fe, Cr, C, TiC, SiC, TiN, and CrN is preferably used.

The particles exemplified as options for the fine particles have high conductivity, but the fine particles are dispersed in the dielectric layer 32, so that the anti-reflective film 30 has insulating property.

The multilayer film (anti-reflective film) 30 shown in FIG. 1 has a laminated structure in which two dielectric layers 32 and 34 are laminated, but the multilayer film (anti-reflective film) in the present embodiment is not limited to this. A laminated structure in which at least two dielectric layers having different refractive indices are laminated may be used. That is, the multilayer film (anti-reflective film) 30 may have a laminated structure in which three or more layers having different refractive indices are laminated. In this case, it is not necessary that all the layers have different refractive indices.

For example, in the case of a three-layer laminated structure, a three-layer laminated structure including a low refractive index layer, a high refractive index layer, and a low refractive index layer, or a three-layer laminated structure including a high refractive index layer, a low refractive index layer, and a high refractive index layer can be used. In the former case, the two low refractive index layers may have the same refractive index. In the latter case, the two high refractive index layers may have the same refractive index.

In the case of a four-layer laminated structure, a four-layer laminated structure including a low refractive index layer, a high refractive index layer, a low refractive index layer, and a high refractive index layer, or a four-layer laminated structure including a high refractive index layer, a low refractive index layer, a high refractive index layer, and a low refractive index layer can be used. In this case, the two low refractive index layers and the two high refractive index layers may each have the same refractive index.

There has been known a halftone mask used in the semiconductor production field as a light transmitting film having light absorptivity and insulating property. As the halftone mask, an oxygen-deficient film such as a Mo-SiO$_x$ film containing a small amount of Mo is used. In addition, as the light transmitting film having light absorptivity and insulating property, there is a narrow-bandgap film used in the semiconductor production field.

However, since these films have light absorptivity on a short wavelength side of visible light, the transmitted light is yellowish. Therefore, these films are not suitable for a cover glass in an image display device.

In the present embodiment, when the layer 32 having an increased content of Mo and the layer 34 formed of SiO$_x$ are provided, it is possible to obtain an anti-reflective film-attached transparent substrate having light absorptivity and insulating property and excellent adhesiveness and strength.

When the multilayer film (anti-reflective film) 30 in the anti-reflective film-attached transparent substrate shown in FIG. 1 has the above configuration, the characteristics of the anti-reflective film-attached transparent substrate according to the present embodiment described above are satisfied.

When the group B content is 65 mass% or less in the layer (A-B-O) 32 formed of the mixed oxide of an oxide containing at least one element selected from the group A consisting of Mo and W and an oxide containing at least one element selected from the group B consisting of Si, Nb, Ti, Zr, Ta, Al, Sn, and In, it is possible to prevent the b* value from exceeding 5.

In the case of a laminated structure in which three or more layers having different refractive indices are laminated, a layer other than the layer (A-B-O) and the layer (SiO$_x$) may be provided. In this case, it is necessary to select each layer so as to have a three-layer laminated structure including a low refractive index layer, a high refractive index layer, and a low refractive index layer, a three-layer laminated structure including a high refractive index layer, a low refractive index layer, and a high refractive index layer, a four-layer laminated structure including a low refractive index layer, a high refractive index layer, a low refractive index layer, and a high refractive index layer, or a four-layer laminated structure including a high refractive index layer, a low refractive index layer, a high refractive index layer, and a low refractive index layer, including the layer (A-B-O) and the layer (SiO$_x$).

The outermost layer is preferably the layer (SiO$_x$). This is because when the outermost layer is the layer (SiO$_x$), the outermost layer can be relatively easily produced in order to obtain low reflectivity. In the case of forming an anti-fouling film, it is preferable to form the anti-fouling film on the layer (SiO$_x$) from the viewpoint of a bonding property relating to durability of the anti-fouling film.

The layer (A-B-O) 32 is preferably amorphous. Being amorphous, the layer (A-B-O) 32 can be formed at a relatively low temperature, and, when the transparent substrate is made of a resin, can be suitably applied without the resin being damaged by heat.

Hereinafter, the anti-reflective film-attached transparent substrate according to the present embodiment is further described.

<Transparent Substrate>

The transparent substrate is preferably made of a material having a refractive index of 1.4 or more and 1.7 or less. This is because, when a display, a touch panel, or the like is optically bonded thereto, reflection on a bonding surface can be sufficiently prevented.

The transparent substrate is preferably a glass substrate or a resin substrate. The transparent substrate may be a laminate formed of a glass and a resin.

As the glass substrate, glasses having various compositions can be used. For example, the glass used in the present embodiment preferably contains sodium, and preferably has a composition that can be strengthened by molding and a chemical strengthening treatment. Specific examples thereof include an aluminosilicate glass, a soda lime glass, a borosilicate glass, a lead glass, an alkali barium glass, and an aluminoborosilicate glass.

The thickness of the glass substrate is not particularly limited, and is usually preferably 5 mm or less, and more preferably 3 mm or less in order to effectively perform the chemical strengthening treatment.

The glass substrate is preferably a chemically strengthened glass in order to increase the strength of the cover glass. When an anti-glare treatment is applied to the glass substrate, the chemical strengthening is performed after the anti-glare treatment and before the multilayer film is formed.

It is preferable that the anti-glare treatment is applied to the main surface of the glass substrate on the side where the multilayer film is provided. The anti-glare treatment method is not particularly limited, and a method of applying a surface treatment to the main surface of the glass to form desired unevenness can be used.

Specific examples thereof include a method of performing a chemical treatment on a main surface of a glass substrate, for example, a method of performing a frosting treatment. In the frosting treatment, for example, a glass substrate to be treated is immersed in a mixed solution of hydrogen fluoride and ammonium fluoride, and the immersed surface can be chemically surface-treated.

In addition to these chemical treatments, physical treatments such as sandblasting, in which a crystalline silicon dioxide powder, a silicon carbide powder, or the like is blown onto the glass substrate surface with pressurized air, or polishing with a brush moistened with water and adhered with a crystalline silicon dioxide powder, a silicon carbide powder, or the like, can be used.

The resin substrate is preferably a resin film. A thermoplastic resin or a thermosetting resin can be used as the resin film. Examples thereof include a polyvinyl chloride resin, a polyethylene resin, a polypropylene resin, a polystyrene resin, a polyvinyl acetate resin, a polyester resin, a polyurethane resin, a cellulose-based resin, an acrylic resin, an acrylonitrile-styrene (AS) resin, an acrylonitrile-butadiene-styrene (ABS) resin, a fluorinebased resin, a thermoplastic elastomer, a polyamide resin, a polyimide resin, a polyacetal resin, a polycarbonate resin, a modified polyphenylene ether resin, a polyethylene terephthalate resin, a polybutylene terephthalate resin, a polylactic acid-based resin, a cyclic polyolefin resin, and a polyphenylene sulfide resin. Among these, a cellulose-based resin is preferred, and a triacetylcellulose resin, a polycarbonate resin, and a polyethylene terephthalate resin are more preferred. These resins may be used alone or in combination of two or more kinds thereof.

Alternatively, the resin substrate is preferably at least one resin selected from a polyethylene terephthalate, polycarbonate, acrylic, silicone or triacetylcellulose resin film.

The thickness of the film is not particularly limited, and is preferably 20 $\mu$m to 150 $\mu$m, and more preferably 40 $\mu$m to 80 $\mu$m.

When a film is used as the transparent substrate 10, as one embodiment, a hard coat layer (not shown) may be disposed on the transparent substrate 10, and the multilayer film (anti-reflective film) 30 may be provided thereon.

Further, as another embodiment, an anti-glare layer (not shown) may be disposed on the hard coat layer, and the multilayer film (anti-reflective film) 30 may be provided thereon.

As the hard coat layer, one obtained by dissolving a polymer resin can be applied. The anti-glare layer increases haze by forming an uneven shape on one surface of the film, thereby imparting the anti-glare property. Similar to the hard coat layer, as the anti-glare layer, one obtained by dissolving a polymer resin can be applied. An anti-glare layer composition constituting the anti-glare layer is formed by dispersing at least a particulate substance having an anti-glare property in a solution in which a polymer resin as a binder is dissolved.

Examples of the particulate substance having an anti-glare property include inorganic fine particles such as silica, clay, talc, calcium carbonate, calcium sulfate, barium sulfate, aluminum silicate, titanium oxide, synthetic zeolite, alumina, and smectite, and organic fine particles formed of a styrene resin, a urethane resin, a benzoguanamine resin, a silicone resin, and an acrylic resin.

Examples of the polymer resin as a binder for the hard coat layer and the anti-glare layer include polymer resins such as a polyester-based resin, an acrylic resin, an acrylic urethane-based resin, a polyester acrylate-based resin, a polyurethane acrylate-based resin, an epoxy acrylate-based resin, and a urethane-based resin.

<Multilayer Film>

The multilayer film described above can be formed on the main surface of the transparent substrate by using known film-formation methods such as a sputtering method, a vacuum deposition method, and a coating method. That is, the dielectric layers or layers constituting the multilayer film are formed on the main surface of the transparent substrate by known film-formation methods such as a sputtering method, a vacuum deposition method, and a coating method according to the lamination order.

Examples of the sputtering method include magnetron sputtering, pulse sputtering, AC sputtering, and digital sputtering.

For example, a magnetron sputtering method is a method in which a magnet is installed on the back surface of a dielectric material serving as a base material to generate a magnetic field, and gas ion atoms collide with the surface of the dielectric material and are knocked out to form a sputtering film having a thickness of several nm. A continuous film of dielectric, which is an oxide or nitride of the dielectric material, can be formed.

For example, a digital sputtering method is a method of forming a metal oxide thin film by repeating, in the same chamber, a step of forming an extremely thin metal film first by sputtering and then oxidizing the extremely thin metal film by irradiation with oxygen plasma, oxygen ions, or oxygen radicals, unlike the normal magnetron sputtering method. In this case, since film-formation molecules are metals when formed on the substrate, it is presumed that the film is more ductile than a case where the film is formed with a metal oxide. Therefore, it is considered that the rearrangement of the film-formation molecules easily occurs even with the same energy, and as a result, a dense and smooth film can be formed.

<Anti-fouling Film>

The anti-reflective film-attached transparent substrate according to the present embodiment may include an anti-fouling film (also referred to as an anti-finger print (AFP) film) on the anti-reflective film from the viewpoint of protecting the outermost surface of the film. The anti-fouling film is formed of, for example, a fluorine-containing organosilicon compound.

The fluorine-containing organosilicon compound is not particularly limited as long as it can impart an antifouling property, water repellency, and oil repellency. Examples thereof include fluorine-containing organosilicon compounds having one or more groups selected from the group consisting of a polyfluoropolyether group, a polyfluoroalkylene group, and a polyfluoroalkyl group. The polyfluoropolyether group is a divalent group having a structure in which a polyfluoroalkylene group and an ether oxygen atom are alternately bonded.

As the commercially available fluorine-containing organosilicon compound having one or more groups selected from the group consisting of a polyfluoropolyether group, a polyfluoroalkylene group, and a polyfluoroalkyl group, KP-801 (trade name, manufactured by Shin-Etsu Chemical Co., Ltd.), KY178 (trade name, manufactured by Shin-Etsu Chemical Co., Ltd.), KY-130 (trade name, manufactured by Shin-Etsu Chemical Co., Ltd.), KY-185 (trade name, manufactured by Shin-Etsu Chemical Co., Ltd.), OPTOOL (registered trademark) DSX and OPTOOL AES (trade names, each manufactured by Daikin Industries, Ltd.), and the like can be preferably used.

The anti-fouling film is laminated on the anti-reflective film. When the anti-reflective film is formed on both main surfaces of the glass substrate or the resin substrate, the anti-fouling film may be formed on both of the anti-reflective films, or the anti-fouling film may be laminated on only one of the surfaces. This is because the anti-fouling film only needs to be provided at a place where the hand of a person may come into contact with the anti-fouling film. The anti-fouling film can be selected according to the use or the like.

The anti-reflective film-attached transparent substrate according to the present embodiment is suitable as a cover glass in an image display device, particularly a cover glass in an image display device to be mounted on a vehicle or the like, such as an image display device of a navigation system to be mounted on a vehicle or the like.

Examples

Hereinafter, the present invention is described in detail with reference to Examples, but the present invention is not limited thereto. Examples 1 to 4 are Examples, and Examples 5 to 7 are Comparative Examples.

(Example 1)

With the following method, an anti-reflective film was formed on one main surface of a transparent substrate to prepare an anti-reflective film-attached transparent substrate.

As the transparent substrate, a chemically strengthened glass substrate (Dragontrail: registered trademark, manufactured by AGC Inc.) with 50 mm (length) $\times$ 50 mm (width) $\times$2 mm (thickness) was used.

An anti-glare TAC film (trade name VZ50 manufactured by TOPPAN TOMOEGAWA OPTICAL FILMS CO., LTD) was bonded to one main surface of the transparent substrate with an acrylic adhesive.

Next, for a dielectric layer (1) (metal oxide layer) by a digital sputtering method, a target obtained by mixing and sintering niobium and molybdenum at a weight ratio of 50:50 was used, and pulse sputtering was performed under conditions of a frequency of 100 kHz, a power density of 10.0 W/cm$^2$, and an inverted pulse width of 3 $\mu$sec while maintaining the pressure at 0.2 Pa with argon gas to form a metal film having a very small thickness, immediately thereafter, oxidation with oxygen gas was performed. These operations were repeated at a high speed to form an oxide film, and a Mo-Nb-O layer with 20 nm was formed on the main surface of the transparent substrate to which a diffusion layer was bonded.

Next, for a dielectric layer (2) (silicon oxide layer) by the same digital sputtering method, a silicon target was used, and pulse sputtering was performed under conditions of a frequency of 100 kHz, a power density of 10.0 W/cm$^2$, and an inverted pulse width of 3 $\mu$sec while maintaining the pressure at 0.2 Pa with argon gas to form a silicon film having a very small thickness, immediately thereafter, oxidation with oxygen gas was performed. These operations were repeated at a high speed to form a silicon oxide film, and a layer made of a silicon oxide [silica (SiO$_x$)] having a thickness of 30 nm was formed and laminated on the Mo-Nb-O layer. Here, an oxygen flow rate during the oxidation with oxygen gas was 500 sccm, and an input power of the oxidation source was 1000 W.

Next, for a dielectric layer (3) (metal oxide layer) by the same digital sputtering method, a target obtained by mixing and sintering niobium and molybdenum at a weight ratio of 50:50 was used, and pulse sputtering was performed under conditions of a frequency of 100 kHz, a power density of 10.0 W/cm$^2$, and an inverted pulse width of 3 $\mu$sec while maintaining the pressure at 0.2 Pa with pressure argon gas to form a metal film having a very small thickness, immediately thereafter, oxidation with oxygen gas was performed. These operations were repeated at a high speed to form an oxide film, and a Mo-Nb-O layer having a thickness of 120 nm was formed and laminated on the silicon oxide layer.

Subsequently, for a dielectric layer (4) (silicon oxide layer) by the same digital sputtering method, a silicon target was used, and pulse sputtering was performed under conditions of a frequency of 100 kHz, a power density of 10.0 W/cm$^2$, and an inverted pulse width of 3 μsec while maintaining the pressure at 0.2 Pa with argon gas to form a silicon film having a very small thickness, immediately thereafter, oxidation with oxygen gas was performed. These operations were repeated at a high speed to form a silicon oxide film, and a layer made of a silicon oxide [silica (SiO$_x$)] having a thickness of 88 nm was formed and laminated on the Mo-Nb-O layer. Here, an oxygen flow rate during the oxidation with oxygen gas was 500 sccm, and an input power of the oxidation source was 1000 W.

The prepared anti-reflective film-attached transparent substrate was subjected to the following evaluation.

(Luminous Transmittance of Anti-reflective Film-attached Transparent Substrate)

The spectral transmittance was measured by a spectrophotometer (trade name: Solid Spec-3700 manufactured by Shimadzu Corporation), and the luminous transmittance (stimulus value Y defined in JIS Z 8701:1999) was determined by calculation.

(Transmission Color (b* Value) under D65 Light Source of Anti-reflective Film-attached Transparent Substrate)

A color index (b* value) specified in JIS Z 8729:2004 was determined based on a transmission spectrum obtained by measuring the spectral transmittance. A D65 light source was used as the light source.

(Luminous Reflectance of Outermost Layer and Diffused Light Brightness for Anti-reflective Film)

The luminous reflectance (SCI Y) of the outermost layer and the diffused light brightness (SCE L*) for the anti-reflective film were measured using a spectrophotometer (trade name: CM2600d manufactured by Konica Minolta, Inc.). The light source was a D65 light source. The luminous reflectance of the outermost layer of the anti-reflective film (reflectance at the outermost surface of the transparent substrate) was measured by attaching a black tape to a back surface of the transparent substrate to eliminate back surface reflection components. The diffused light brightness was measured in a state where the non-film-formed surface of the anti-reflective film-attached transparent substrate was bonded to a liquid crystal display using an acrylic adhesive.

(Sheet Resistance of Anti-reflective Film)

The sheet resistance value was measured using a measuring device (device name: Hiresta UP (MCP-HT450 type) manufactured by Mitsubishi Chemical Analytech Co., Ltd.). A probe was placed on a center of the anti-reflective film-attached transparent substrate, and the measurement was performed by applying a current at 10 V for 10 seconds.

(Diffusion Value)

Measurement was performed using a measuring device (device SMS-1000 manufactured by DM&S), and the Diffusion value was calculated according to the method described above. The results are shown in Table 1 below.

(Example 2)

Film formation was performed in the same manner as in Example 1, except that the oxygen gas flow rate was changed from 500 sccm to 800 sccm when forming the metal oxide layers for the dielectric layers (1) and (3). The evaluation results for the obtained anti-reflective film-attached transparent substrate are shown in Table 1 below.

(Example 3)

An anti-reflective film was formed by laminating a dielectric layer in the same manner as in Example 1, except that an anti-glare TAC film (trade name DSR3 manufactured by Dai Nippon Printing Co., Ltd.) was bonded to one main surface of the transparent substrate with an acrylic adhesive. The evaluation results for the obtained anti-reflective film-attached transparent substrate are shown in Table 1 below.

(Example 4)

An anti-reflective film was formed by laminating a dielectric layer in the same manner as in Example 1, except that an anti-glare TAC film (trade name VH66H manufactured by TOPPAN TOMOEGAWA OPTICAL FILMS CO., LTD) was bonded as a diffusion layer to one main surface of the transparent substrate with an acrylic adhesive, as in Example 1. The evaluation results for the obtained anti-reflective film-attached transparent substrate are shown in Table 1 below.

(Example 5)

An anti-glare TAC film (trade name VZ50 manufactured by TOPPAN TOMOEGAWA OPTICAL FILMS CO., LTD) was bonded as a diffusion layer to one main surface of the transparent substrate with an acrylic adhesive, as in Example 1. An anti-reflective film including titanium oxide and silicon oxide was formed on the diffusion layer by the following method.

As a method for forming the anti-reflective film, first, for a dielectric layer (1) (metal oxide layer) by a digital sputtering method, a titanium target was used, and pulse sputtering was performed under conditions of a frequency of 100 kHz, a power density of 10.0 W/cm$^2$, and an inverted pulse width of 3 $\mu$sec while maintaining the pressure at 0.2 Pa with argon gas to form a metal film having a very small thickness, immediately thereafter, oxidation with oxygen gas was performed. These operations were repeated at a high speed to form an oxide film, and a Ti-O layer with 11 nm was formed on the main surface of the transparent substrate to which the diffusion layer was bonded.

Next, for a dielectric layer (2) (silicon oxide layer) by the same digital sputtering method, a silicon target obtained was used to be subjected to pulse sputtering under conditions of a frequency of 100 kHz, a power density of 10.0 W/cm$^2$, and an inverted pulse width of 3 $\mu$sec while maintaining the pressure at 0.2 Pa with argon gas to form a silicon film having a very small thickness, immediately thereafter, oxidation with oxygen gas was performed. These operations were repeated at a high speed to form a silicon oxide film, and a layer made of a silicon oxide [silica (SiO$_x$)] having a thickness of 35 nm was formed and laminated on the Ti-O layer. Here, an oxygen flow rate during the oxidation with oxygen gas was 500 sccm, and an input power of the oxidation source was 1000 W.

Next, for a dielectric layer (3) (metal oxide layer) by the same digital sputtering method, a titanium target was used, and pulse sputtering was performed under conditions of a frequency of 100 kHz, a power density of 10.0 W/cm$^2$, and an inverted pulse width of 3 $\mu$sec while maintaining the pressure at 0.2 Pa with argon gas to form a metal film having a very small thickness, immediately thereafter, oxidation with oxygen gas was performed. These operations were repeated at a high speed to form an oxide film, and a Ti-O layer having a thickness of 104 nm was formed and laminated on the silicon oxide layer.

Subsequently, for a dielectric layer (4) (silicon oxide layer) by the same digital sputtering method, a silicon target was used, and pulse sputtering was performed under conditions of a frequency of 100 kHz, a power density of 10.0 W/cm$^2$, and an inverted pulse width of 3 $\mu$sec while maintaining the pressure at 0.2 Pa with argon gas to form a silicon film having a very small thickness, immediately thereafter, oxidation with oxygen gas was performed. These operations were repeated at a high speed to form a silicon oxide film, and a layer made of a silicon oxide [silica (SiO$_x$)] having a thickness of 86 nm was formed and laminated on the Ti-O layer. Here, an oxygen flow rate during the oxidation with oxygen gas was 500 sccm, and an input power of the oxidation source was 1000 W. The evaluation results for the obtained anti-reflective film-attached transparent substrate are shown in Table 1 below.

(Example 6)

An anti-reflective film was formed by laminating a dielectric layer in the same manner as in Example 1, except that a clear hard coat TAC film (trade name CHC manufactured by TOPPAN TOMOEGAWA OPTICAL FILMS CO., LTD) was bonded to one main surface of the transparent substrate with an acrylic adhesive. The evaluation results for the obtained anti-reflective film-attached transparent substrate are shown in Table 1 below.

(Example 7)

An anti-reflective film was formed by laminating a dielectric layer in the same manner as in Example 1, except that an anti-glare TAC film (trade name VZ50 manufactured by TOPPAN TOMOEGAWA OPTICAL FILMS CO., LTD) was bonded as a diffusion layer to one main surface of the transparent substrate with an acrylic adhesive, as in Example 1, and the thickness of each layer was adjusted to increase the reflectance. The evaluation results for the obtained anti-reflective film-attached transparent substrate are shown in Table 1 below.

The evaluations described above were carried out on the anti-reflective film-attached transparent substrates in Examples 1 to 7. The results are shown in Tables 1 and 2 below.

[Table 1]

| | | Example 1 | Example 2 | Example 3 | Example 4 |
|---|---|---|---|---|---|
| Structure | Substrate | Glass | Glass | Glass | Glass |
| | | Anti-glare TAC film (VZ50) | Anti-glare TAC film (VZ50) | Anti-glare TAC film (DSR3) | Anti-glare TAC film (VH66H) |
| | Dielectric layer (1) | Mo-Nb-O [20 nm] | Mo-Nb-O [20 nm] | Mo-Nb-O [20 nm] | Mo-Nb-O [20 nm] |
| | Dielectric layer (2) | $SiO_x$ [30 nm] | $SiO_x$ [30 nm] | $SiO_x$ [30 nm] | $SiO_x$ [30 nm] |
| | Dielectric layer (4) | Mo-Nb-O [120 nm] | Mo-Nb-O [120 nm] | Mo-Nb-O [120 nm] | Mo-Nb-O [120 nm] |
| | Dielectric layer (4) | $SiO_x$ [88 nm] | $SiO_x$ [88 nm] | $SiO_x$ [88 nm] | $SiO_x$ [88 nm] |
| Film-formation method | | Digital sputtering | Digital sputtering | Digital sputtering | Digital sputtering |
| Luminous transmittance (%) | | 73 | 89 | 87 | 88 |
| Transmission color b* | | 1.7 | 1.3 | 1.3 | 1.3 |
| SCI (Y) luminous reflectance (%) of outermost layer of anti-reflective film | | 0.34 | 0.24 | 0.32 | 0.36 |
| SCI (Y) luminous reflectance (%) | | 0.98 | 1.26 | 1.42 | 1.49 |
| Sheet resistance ($\Omega$/square) | | $1 \times 10^{10}$ | $1 \times 10^{10}$ | $1 \times 10^{10}$ | $1 \times 10^{10}$ |
| Diffused light brightness (SCE (L*)) | | 2.4 | 3.2 | 3.79 | 3.04 |
| Diffusion value | | 0.45 | 0.45 | 0.45 | 0.25 |

[Table 2]

| | | Example 5 | Example 6 | Example 7 |
|---|---|---|---|---|
| Structure | Substrate | Glass | Glass | Glass |
| | | Anti-glare TAC film (VZ50) | Anti-glare TAC film (CHC) | Anti-glare TAC film (VZ50) |
| | Dielectric layer (1) | $TiO_2$ [11 nm] | Mo-Nb-O [20 nm] | Mo-Nb-O [10 nm] |
| | Dielectric layer (2) | $SiO_x$ [35 nm] | $SiO_x$ [30 nm] | $SiO_x$ [36 nm] |
| | Dielectric layer (4) | $TiO_2$ [104 nm] | Mo-Nb-O [120 nm] | Mo-Nb-O [125 nm] |
| | Dielectric layer (4) | $SiO_x$ [86 nm] | $SiO_x$ [88 nm] | $SiO_x$ [90 nm] |
| Film-formation method | | Digital sputtering | Digital sputtering | Digital sputtering |
| Luminous transmittance (%) | | 95 | 88 | 87 |
| Transmission color b* | | 0.4 | 1.3 | 1.3 |
| SCI (Y) luminous reflectance (%) of outermost layer of anti-reflective film | | 0.12 | 0.32 | 0.42 |
| SCI (Y) luminous reflectance (%) | | 1.53 | 1.40 | 1.47 |
| Sheet resistance ($\Omega$/square) | | $1 \times 10^{10}$ | $1 \times 10^{10}$ | $1 \times 10^{10}$ |
| Diffused light brightness (SCE (L*)) | | 4.5 | 0.9 | 4.05 |
| Diffusion value | | 0.45 | 0.05 | 0.45 |

# EP 4 186 690 A1

As seen from Tables 1 and 2, the anti-reflective film-attached transparent substrates in Examples 1 to 4 are each an anti-reflective film-attached transparent substrate including: a transparent substrate having two main surfaces; and a diffusion layer and an anti-reflective film on one main surface of the transparent substrate, which are provided in this order, in which

(A) a luminous transmittance is 20% to 90%,
(B) a transmission color b* value under a D65 light source is 5 or less,
(C) a luminous reflectance (SCI Y) of an outermost layer of the anti-reflective film is 0.4% or less,
(D) a sheet resistance of the anti-reflective film is $10^4$ Ω/square or more,
(E) the anti-reflective film has a laminated structure in which at least two dielectric layers having different refractive indices are laminated, and
(F) a Diffusion value is 0.2 or more and a diffused light brightness (SCE L*) is 4 or less. As compared with Examples 5 to 7, the anti-reflective film-attached transparent substrates in Examples 1 to 4 have light absorptivity and insulating property, and the transmitted light thereof is not yellowish.

Although various embodiments have been described above with reference to the drawings, it is needless to say that the present invention is not limited to such embodiments. It is apparent to those skilled in the art that various changes and modifications can be conceived within the scope of the claims, and it is also understood that such variations and modifications belong to the technical scope of the present invention. Components in the embodiments described above may be combined freely within a range not departing from the spirit of the invention.

The present application is based on a Japanese patent application (No. 2020-125648) filed on July 22, 2020, contents of which are incorporated herein by reference.

REFERENCE SIGNS LIST

10 transparent substrate
30 multilayer film (anti-reflective film)
31 diffusion layer
32, 34 dielectric layer
212 first surface
214 second surface
300 measuring device
350 light source
362 first light
364 first reflected light
366 second reflected light
368 third reflected light
370 detector
A transparent substrate

## Claims

1. An anti-reflective film-attached transparent substrate comprising: a transparent substrate comprising two main surfaces; and a diffusion layer and an anti-reflective film on one main surface of the transparent substrate, which are provided in this order, wherein

(A) a luminous transmittance is 20% to 90%,
(B) a transmission color b* value under a D65 light source is 5 or less,
(C) a luminous reflectance (SCI Y) of an outermost layer of the anti-reflective film is 0.4% or less,
(D) a sheet resistance of the anti-reflective film is $10^4$ Ω/square or more,
(E) the anti-reflective film has a laminated structure in which at least two dielectric layers having different refractive indices are laminated, and
(F) a Diffusion value is 0.2 or more and a diffused light brightness (SCE L*) is 4 or less.

2. The anti-reflective film-attached transparent substrate according to claim 1,

wherein at least one of the dielectric layers is mainly formed of an Si oxide,

at least another layer in layers of the laminated structure is mainly formed of a mixed oxide of an oxide containing at least one element selected from the group A consisting of Mo and W and an oxide containing at least one element selected from the group B consisting of Si, Nb, Ti, Zr, Ta, Al, Sn, and In, and

a content of the elements of the group B contained in the mixed oxide is 65 mass% or less with respect to a total of the elements of the group A contained in the mixed oxide and the elements of the group B contained in the mixed oxide.

3. The anti-reflective film-attached transparent substrate according to claim 1 or 2, further comprising an anti-fouling film on the anti-reflective film.

4. The anti-reflective film-attached transparent substrate according to any one of claims 1 to 3, wherein the transparent substrate is a glass substrate.

5. The anti-reflective film-attached transparent substrate according to any one of claims 1 to 3, wherein the transparent substrate is at least one resin selected from a polyethylene terephthalate, polycarbonate, acrylic, silicone, or triacetylcellulose resin film.

6. The anti-reflective film-attached transparent substrate according to any one of claims 1 to 3, wherein the transparent substrate is a laminate of a glass and at least one resin selected from a polyethylene terephthalate, polycarbonate, acrylic, silicone, or triacetylcellulose resin film.

7. The anti-reflective film-attached transparent substrate according to claim 4 or 6, wherein the glass is chemically strengthened.

8. The anti-reflective film-attached transparent substrate according to any one of claims 1 to 7, wherein the main surface of the transparent substrate on a side where the anti-reflective film is provided is subjected to an anti-glare treatment.

9. An image display device comprising the anti-reflective film-attached transparent substrate according to any one of claims 1 to 8.

## FIG. 1

## FIG. 2

## INTERNATIONAL SEARCH REPORT

International application No.

PCT/JP2021/026878

### A. CLASSIFICATION OF SUBJECT MATTER

Int. Cl. B32B9/00(2006.01)i, B32B17/00(2006.01)i, C03C17/38(2006.01)i, C03C21/00(2006.01)i, G09F9/00(2006.01)i, B32B7/023(2019.01)i
FI: C03C17/38, C03C21/00 101, B32B7/023, B32B9/00 A, B32B17/00, G09F9/00 302, G09F9/00 313

According to International Patent Classification (IPC) or to both national classification and IPC

### B. FIELDS SEARCHED

Minimum documentation searched (classification system followed by classification symbols)
Int. Cl. B32B1/00-43/00, C03C15/00-23/00, C23C14/00-14/58, G09F9/00

Documentation searched other than minimum documentation to the extent that such documents are included in the fields searched
Published examined utility model applications of Japan      1922-1996
Published unexamined utility model applications of Japan    1971-2021
Registered utility model specifications of Japan            1996-2021
Published registered utility model applications of Japan    1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2018-115105 A (ASAHI GLASS CO., LTD.) 26 July 2018 (2018-07-26), entire text | 1-9 |
| A | WO 2019/017072 A1 (AGC INC.) 24 January 2019 (2019-01-24), entire text | 1-9 |
| A | JP 2018-146789 A (AGC INC.) 20 September 2018 (2018-09-20), entire text | 1-9 |
| A | JP 2016-502592 A (HERAEUS DEUTSCHLAND GMBH & CO KG) 28 January 2016 (2016-01-28), entire text | 1-9 |

☐ Further documents are listed in the continuation of Box C.        ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 01.09.2021 | 14.09.2021 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

Information on patent family members

International application No.

PCT/JP2021/026878

| Patent Documents referred to in the Report | Publication Date | Patent Family | Publication Date |
|---|---|---|---|
| JP 2018-115105 A | 26.07.2018 | US 2018/0203354 A1<br>entire document<br>US 2020/0123049 A1<br>DE 102018000306 A<br>CN 108312655 A | |
| WO 2019/017072 A1 | 24.01.2019 | US 2020/0142105 A1<br>entire document<br>EP 3657476 A1<br>CN 110870000 A | |
| JP 2018-146789 A | 20.09.2018 | (Family: none) | |
| JP 2016-502592 A | 28.01.2016 | WO 2014/063954 A1<br>WO 2014/063953 A2<br>EP 2912500 A1<br>EP 2912501 A1<br>DE 102012112742 A<br>DE 102012112739 A1<br>TW 201430158 A<br>TW 201434659 A<br>KR 10-2015-0079810 A<br>KR 10-2015-0079811 A<br>CN 104919340 A<br>CN 104937443 A<br>JP 2016-504484 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018115105 A
- JP 2016068470 A
- JP 2008201633 A
- JP 2020125648 A